# EUROPEAN PATENT APPLICATION

(11) **EP 4 601 134 A1**
(43) Date of publication of application: **13.08.2025**
(21) Application number: 23955006.4
(22) Date of filing: 11.12.2023
(51) Int. Cl.: H01S 5/02315

(54) **LASER PACKAGING MODULE**

(30) Priority: 15.11.2023 CN 202323093783 U
(71) Applicant: Shenzhen Rubeust Technology Limited, Shenzhen, Guangdong 518000 (CN)
(72) Inventor: TANG, Huai, Shenzhen, Guangdong 518000 (CN); LI, Xiangyu, Shenzhen, Guangdong 518000 (CN); GUO, Yanyu, Shenzhen, Guangdong 518000 (CN)
(74) Representative: Noréns Patentbyrå AB
(86) International application number: PCT/CN2023/137868
(87) International publication number: WO 2025/102464

(57) **Abstract**

The present disclosure provides a laser encapsulation module, including: a base, wherein the base includes a boss, an optical window pad, an inner pad and an outer pad, and the inner pad and the outer pad are conducted through an inner circuit layer of the base; an optical window, welded on the optical window pad of the base, wherein the optical window and the base form an accommodating space; a laser assembly, wherein the laser assembly is arranged on the boss of the base and accommodated in the accommodating space, and is electrically connected to the inner pad, and wherein laser emitted by the laser assembly exits through the optical window. The optical window and the base of the laser encapsulation module in the present disclosure are welded through brazing, which reduces the process difficulty of the laser encapsulation module on the premise of ensuring the welding quality.

## Description

### TECHNICAL FIELD

The present disclosure relates to the technical field of optics, and in particular to a laser encapsulation module.

### BACKGROUND

With the continuous improvement of the electro-optical conversion efficiency and output optical power of the laser chips and the continuous breakthrough of the laser source technology, laser chips have been more and more widely applied in the fields of laser illumination and display. In order to meet market demands, laser chip encapsulating technology has also been continuously advanced and improved. Sealing is a crucial factor in determining product cost and quality. Existing laser chips adopt dispensing sealing, which has poor reliability and product quality, thereby further limiting the further development of laser chip encapsulating technology.

### SUMMARY

The purpose of the present disclosure is to provide a novel laser encapsulation module to solve the above-mentioned problems.

Embodiments of the present disclosure achieve the above purpose through the following technical solutions.

The present disclosure provides a laser encapsulation module, including: a base, an optical window and a laser assembly. The base includes a boss, an optical window pad, an inner pad and an outer pad. The inner pad and the outer pad are conducted through an inner circuit layer of the base. The optical window is welded on the optical window pad of the base. The optical window and the base form an accommodating space. The laser assembly is arranged on the boss of the base. The laser assembly is accommodated in the accommodating space. The laser assembly is electrically connected to the inner pad. The laser emitted by the laser assembly exits through the optical window.

In an embodiment, the laser encapsulation module further includes a collimating lens installed at a side of the optical window away from the base. The collimating lens is configured to shape light emitted from the laser assembly into parallel light.

In an embodiment, the collimating lens includes two collimating lens units, and each of the collimating lens corresponds to one laser assembly, so as to collimate the laser emitted by the laser assembly.

In an embodiment, the optical window has a hollow cylindrical structure, a cross section of the optical window in a direction perpendicular to the base is of a circular ring, and a width of the circular ring is less than a width of the optical window pad.

In an embodiment, the optical window includes a side wall and a top wall. The side wall encloses to form a ring shape and is connected to the top wall. A middle region of the top wall is provided with a light transmitting portion. The light transmitting portion is configured to transmit light emitted from the laser assembly.

In an embodiment, the laser assembly includes a laser chip, a heat sink carrier and a reflector. The heat sink carrier is arranged on the boss of the base, the laser chip is arranged on the heat sink carrier, and the reflector is arranged in an optical path of light emitted from the laser chip.

In an embodiment, the reflecting member includes a reflecting surface opposite to a light outlet of the laser chip, and the reflecting surface forms an included angle of 45° with a plane of the base.

In an embodiment, the laser assembly may include a plurality of groups of laser chips and reflectors, and the plurality of groups of laser chips and reflectors are arranged on the base in arrays.

In an embodiment, the base is a double-layer Motor Protection Circuit Board (MPCB). The double-layer MPCB is made of copper material.

In an embodiment, the inner pad is arranged inside the accommodating space. The outer pad is arranged outside the accommodating space. The double-layer MPCB includes an inner circuit layer. The inner circuit layer is embedded in the base. The inner pad and the outer pad are conducted to each other through the inner circuit layer.

Compared with the related art, the optical window and the base of the laser encapsulation module in the present disclosure are welded through brazing, which reduces the process difficulty of the laser encapsulation module on the premise of ensuring the welding quality. In addition, the collimating lens is mounted on the optical window, so that the laser can be collimated and emitted. By providing the double-layer MPCB, the bonding pad sealed in the accommodating space is led out through the inner circuit layer of the double-layer MPCB, which improves the process yield of the laser encapsulation module and enhances the sealing reliability of the laser encapsulation module.

These aspects or other aspects of the present disclosure will be more clearly understood in following described embodiments.

### BRIEF DESCRIPTION OF DRAWINGS

In order to more clearly describe the technical solutions of embodiments of the present disclosure, drawings required for illustrating embodiments will be briefly introduced as below. It is appreciated that, the drawings described below are merely some embodiments of the present disclosure, and for those skilled in the art, other drawings can be obtained based on these drawings without any creative effort.
FIG. 1 is a schematic diagram of an overall structure of a laser encapsulation module according to the present disclosure.
FIG. 2 is a schematic structural diagram of an optical window of a laser encapsulation module according to the present disclosure.
FIG. 3 is a schematic structural diagram of a base of a laser encapsulation module according to the present disclosure.
FIG. 4 is a schematic structural diagram of a base of a laser encapsulation module according to the present disclosure.
FIG. 5 is a schematic structural diagram of a base and an optical window of a laser encapsulation module according to the present disclosure.
FIG. 6 is a schematic structural diagram of a base, an optical window and a collimating lens of a laser encapsulation module according to the present disclosure.
FIG. 7 is a schematic structural diagram of a laser assembly of a laser encapsulation module according to the present disclosure.
FIG. 8 is a schematic structural diagram of a base circuit layer of a laser encapsulation module according to the present disclosure.

### DESCRIPTION OF EMBODIMENTS

To facilitate understanding of the present disclosure, the present disclosure will be described more comprehensively below with reference to the drawings. Preferred embodiments of the present disclosure are shown in the drawings. However, the present disclosure can be embodied in many different forms and should not be limited to the implementations described herein. Rather, these implementations are provided for understanding the present disclosure more thoroughly and comprehensively.

Unless otherwise defined, all technical and scientific terms used herein have the same meaning as commonly understood by those skilled in the art pertaining to the present disclosure. The terms used herein in the embodiments of the present disclosure are just for the purpose of describing specific implementations, but not intended to limit the present disclosure.

The present disclosure provides a laser encapsulation module, including: a base, an optical window and a laser assembly. The base includes a boss, an optical window pad, an inner pad and an outer pad. The inner pad and the outer pad are conducted through an inner circuit layer of the base. The optical window is welded on the optical window pad of the base. The optical window and the base form an accommodating space. The laser assembly is arranged on the boss of the base. The laser assembly is accommodated in the accommodating space. The laser assembly is electrically connected to the inner pad. The laser emitted by the laser assembly exits through the optical window.

Technical solutions of the present disclosure are described below through specific embodiments.

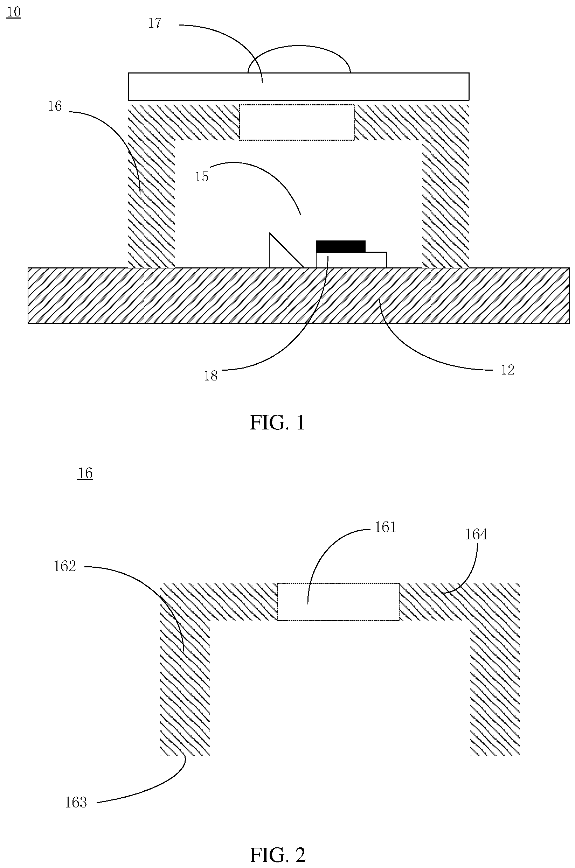

Referring to FIG. 1, FIG. 2 and FIG. 3, the present disclosure provides a laser encapsulation module 10, including a base 12, an optical window 16, a collimating lens 17 and a laser assembly 18. The optical window 16 is arranged on the base 12 and encloses to form an accommodating space 15. A light transmitting portion 161 is arranged in a side of the optical window 16 away from the base 12. The optical window 16 has a top wall 164 away from the base 12 and a side wall 162 connected to the top wall. A brazing layer is provided on a surface of a side wall region of the optical window 16 facing the base 14, so that the optical window 16 and the base 12 are connected to form a sealed accommodating space 15. The collimating lens 17 is installed at a side, away from the base 12, of the optical window 16. The collimating lens 17 is configured to shape light emitted from the laser assembly into parallel light. The collimating lens 17 is bonded to the optical window 16 with glue. The laser assembly 18 is located in the accommodating space 15. The laser emitted by the laser assembly 18 finally exists from the light transmitting portion 161 of the optical window 16.

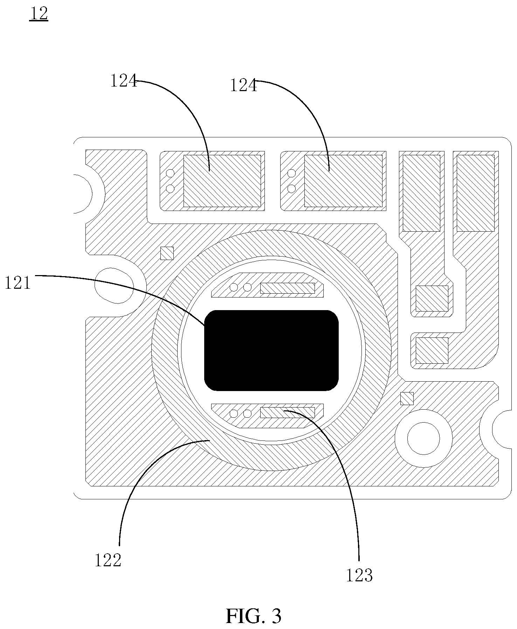

Referring to FIG. 3, the base 12 has a substantially plate-shaped structure, which may be a regular shape, such as rectangle, circle, ellipse, or hexagon, or may be other irregular shapes. The base 12 can be configured for mounting the laser assembly 18 and the optical window 16. In an embodiment, the base 12 is an MPCB double-layer printed circuit board. The base 12 may be made of a copper substrate. The metal substrate has better thermal conductivity, which is more conducive to heat dissipation of the laser assembly 18. In other embodiments, the base 12 may be made of ceramic or the like, as long as it satisfies the installation requirements of the optical window 16. Further, the base 12 includes a boss 121. The boss 121 is configured to arrange the laser assembly 18. The base 12 further includes an optical window pad 122 configured to be connected to the side wall of the optical window 16. The base 12 is further provided with an inner pad 123. The inner pad 123 is connected to the laser assembly 18 via a gold wire to implement electrical input of the laser assembly 18. The base 12 is further provided with an outer pad 124 configured to be connected to a power supply. The power supply implements electrical driving of the laser assembly 18 by using the outer pad. It should be noted that outer and inner pads are merely a relative relationship, rather than actual exterior and interior. In this embodiment, the exterior refers to being outside the accommodating space, and the interior refers to being inside the accommodating space. Further, due to the usage of the double-layer MPCB in the base 12, the inner and outer pads are conducted through the double-layer MPCB, thereby enabling the electrical driving of the laser assembly 18 in the storage space 15.

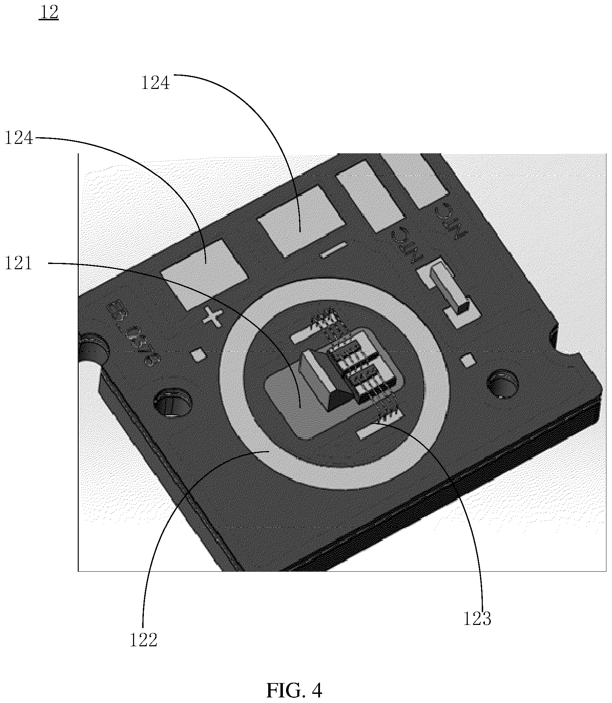

Referring to FIG. 2 and FIG. 4, in an embodiment, the optical window 16 is of a hollow cylindrical structure. That is, a cross section of the optical window 16 in a direction perpendicular to the base 12 is substantially a circular ring. A width of the circular ring is less than that of the optical window pad. In order to ensure the reliability of welding with the base 12, it can be integrally formed, or can be formed by welding several metal plates. It should be noted that the optical window 16 of this embodiment is substantially a hollow cylindrical structure, which means that the cross section of the optical window is of a circular ring, and the corners of the circular ring are not regular corners. The accommodating space 15 formed by the optical window 16 and the base 12 can be configured to receive the laser assembly 18. The material of the optical window 16 can be the same as that of the base 12, for example, metal material, or can be different from that of the base 12, for example, ceramic material.

In some other embodiments, the optical window 16 may also be a substantially hollow polygonal prism structure, that is, the cross section of the optical window 16 is substantially a polygonal ring. It can be understood that the optical window 16 may also be in the shape of a hollow hexagonal prism or the like, as long as it satisfies the accommodation effect for the laser assembly 18.

Further, as shown in FIG. 2, the optical window 16 includes a side wall 162 and a top wall 164. The side wall 162 encloses to form a ring shape and is connected to the circular top wall 164. The light transmitting portion 161 is provided in the middle region of the circular top wall 164. The light transmitting portion 161 is configured to transmit light emitted from the laser assembly 18. A surface 163 of the side wall 162 opposite to the base 12 is connected to the base by brazing, to form a sealed the accommodating space 15. It should be noted that the side wall and the top wall of the optical window can be integrally formed, or can be formed by connecting two components. A chamfer is arranged at a joint of the side wall and the top wall of the optical window, to improve usage intensity of the optical window.

The optical window 16 is located on the base 12 and encloses to form the accommodating space 15. In an embodiment, the optical window 16 is welded to the base by soft soldering. In other embodiments, the base 12 or a side of the optical window 16 close to the base 12 can be coated with an adhesive layer, and the optical window 16 is mounted on the base 12 by bonding.

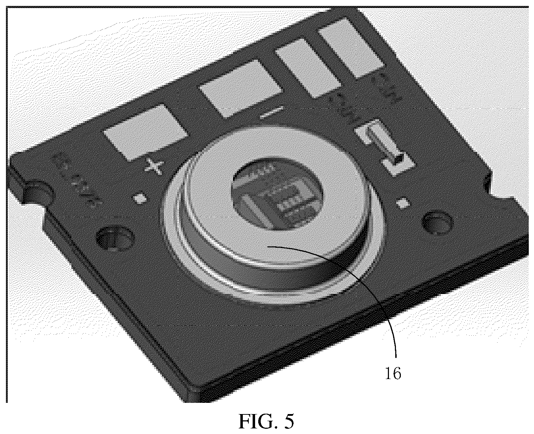

Still referring to FIG. 2 and FIG. 5, the optical window 16 has a substantially annular shape. The material of the optical window 16 may be optical glass or sapphire. The optical window 16 may be made of light-transmitting material, so as to protect the laser assembly 18 in the accommodating space without affecting the emission of the light beam, thereby preventing dust from falling into the laser assembly 18, and thus reducing the influence of water vapor and the like on the laser assembly 18. In an embodiment, the light window 16 is composed of light transmitting material, and a light transmitting portion is provided in the central region of the top wall of the light window 16. In an embodiment, the optical window 16 can be partially provided with a light transmitting region, that is, an area corresponding to the light outlet of the laser chip is provided with a light-transmitting region, and other areas thereof are provided with a non-light-transmitting region. Such design has an advantage that spot shaping can be synchronously realized.

A portion of the side wall surface 163 of the optical window 16 facing the base 12 is provided with a metal layer. An outer edge of the metal layer can be flush with an outer edge of the optical window 16, and an inner edge of the metal layer can be flush with an inner edge of the optical window 16, so as to increase a welding region between the optical window 16 and the base 12, thereby increasing connection strength between the optical window 16 and the base 12.

In an embodiment, the width of the side wall 162 of the optical window 16 is less than the width of the optical window pad of the base 12. The purpose of such design is to enlarge the welding region between the optical window 16 and the base 12, so that the optical window is completely welded on the base 12, thereby increasing the sealing performance after welding and thus improving the stability of encapsulating.

In an embodiment, the solder may be a circular ring integral solder tab, and the material may be Sn96.5Ag3.0Cu0.5, or a solder tab of SnAgCu in other proportions close to this proportion, or a solder tab of other compositions with a melting point lower than 260°C (such as SnAgInBi).

In some other embodiments, the solder can further include sections of solder tabs. There can be a gap between the solder tabs. The sections of solder tabs can be spliced into a circular ring structure.

In some other embodiments, the solder may also have other irregular shapes, which can be specifically selected according to actual conditions, as long as the optical window 16 can seal the base 12 after the solder is melted.

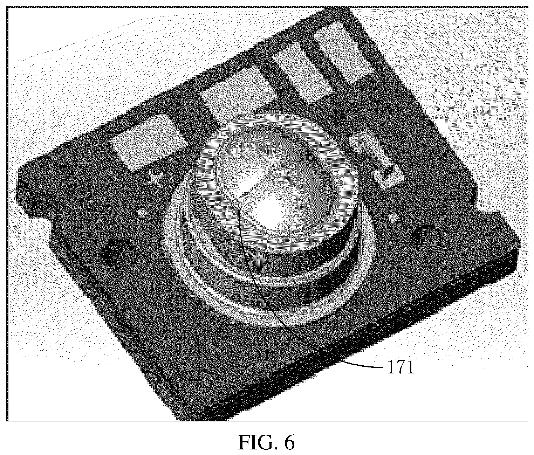

Still referring to FIG. 1 and FIG. 6, the collimating lens 17 can include two collimating lens units. In an embodiment, each collimating lens unit corresponds to one laser assembly 18 to collimate the laser emitted by the laser assembly 18, thereby improving the imaging quality of the laser. The collimating lens 17 can be bonded to the optical window with UV glue, or other thermosetting adhesives or other adhesives that have good adhesion properties to glass materials and low stress. It can be understood that, in other embodiments, the collimating lens can be formed integrally with the optical window, that is, the optical window protrudes corresponding to the surface region of the light outlet of the laser chip, so as to collimate the laser. This method has an advantage that the laser encapsulation module eliminates one step of assembling the collimating lens, thereby making the assembly simple. However, the difficulty of the manufacturing process with the optical window will increase.

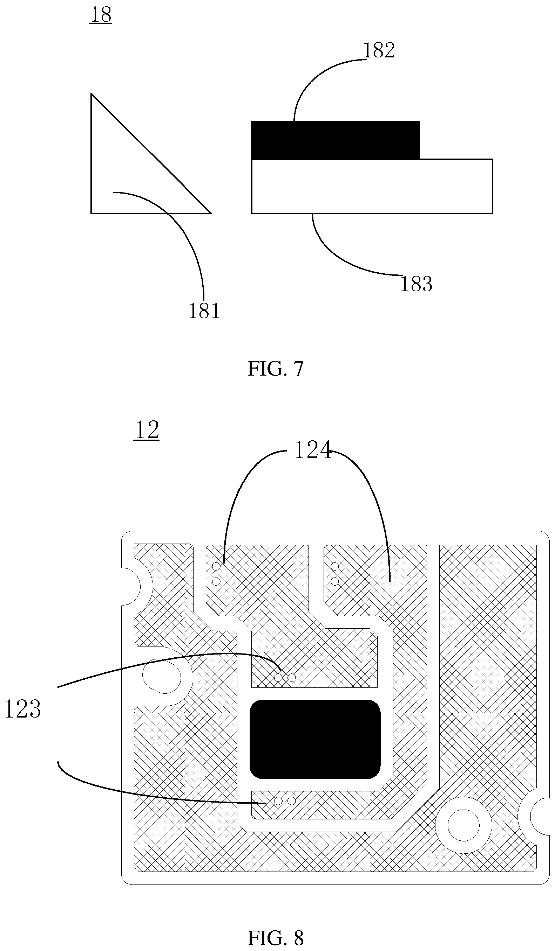

Referring to FIG. 7, the laser assembly 18 is received in the accommodating space and configured to emit laser through the optical window 16. In an embodiment, the laser assembly 18 is arranged in a region enclosed by a projection of an inner wall of the optical window onto the base 12. The laser assembly 18 includes a laser chip 182 and a reflector 181. Both of the laser chip 182 and the reflector 181 are housed in a containment space. The laser chip 182 is configured to emit laser. In an embodiment, the laser assembly 18 further includes a heat sink carrier 183. The laser chip 182 is arranged on a surface of the heat sink carrier 183. The heat sink carrier 183 is configured to dissipate heat of the laser chip 182. The heat sink carrier is welded on the boss of the base by soft soldering. In other embodiments, multiple laser chips correspond to a heat sink carrier. That is, multiple laser chips are arranged on the surface of the heat sink carrier and share one heat sink carrier for heat dissipation. The reflecting member 181 is configured to reflect the laser towards the light-transmitting region of the optical window 16. In an embodiment, the reflecting member 181 includes a reflecting surface opposite to the light outlet of the laser chip, and the reflecting surface forms an included angle of 45° with the plane of the base.

In an embodiment, the laser encapsulation module includes two groups of laser assembles. Each group of laser assemblies includes a laser chip 182, a reflector 181 and a heat sink carrier 183. Two reflectors 181 are located between the two laser chips 182 and arranged opposite to each other. The reflecting surfaces of the reflectors 181 face the light outlet direction of the laser chips. The included angle between the reflecting surface and the plane where the base 12 is located can be 45°. The laser emitted by the laser chip 182 can be emitted to the reflecting surface along a direction parallel to the plane where the base 12 is located, so that the laser is reflected by the reflecting surface of the reflector 181 and eventually emitted along a direction perpendicular to the plane of the optical window 16. That is, the laser is emitted from the top of the laser encapsulation module 10 along a direction perpendicular to the incident direction, namely ejection light. In this case, the output light is maximum.

In other embodiments, the angle between the reflecting surface and the plane where the base 12 is located can be other angles, such as 30° or 60°. In some other embodiments, the laser emitted by the laser chip 182 can also be emitted to the reflecting surface along a direction forming an angle with the plane where the base 12 is located. For example, the angle may be 30°.

In some other embodiments, there can be multiple groups of laser assemblies. That is, there can be three, four or more groups of laser chips 182 and reflectors 181. The multiple groups of laser chips 182 and reflectors 181 can be arranged in an array or irregularly on the base 12.

FIG. 8 shows the principle of an intermediate circuit of a double-layer MPCB according to the present disclosure. In an embodiment, the base 12 further includes an inner circuit layer. The inner circuit layer is arranged in the base 12. That is, the circuit layer is embedded in the base. The inner pad and the outer pad are conducted by the circuit layer, so as to supply power to the bonding pad via a power supply. The outer pad transmits the electric drive to the inner pad through the inner circuit layer. The inner pad is connected to the laser chip 182 through a gold wire, to implement supplying power to the laser chip 182, so that the laser chip 182 can emit laser.

The operation steps of sealing and welding the optical window 16 of the present disclosure are as below.
1. The laser assembly 18, the solder, the optical window 16, and the clamp that had been dehydrated and baked were placed in a sealed container filled with nitrogen.
2. The optical window 16 provided with a laser assembly 18 and various elements was placed on the clamp within the sealed container.
3. Solder was placed in the optical window pad region 122 of the base 12.
4. The optical window 16 was placed on the solder tab and aligned with the optical window pad region 122 of the base 12.
5. The optical window 16 and the base 12 were tightly pressed and fixed together on the clamps. The specific number of the clamps depends on requirements.
6. The clamp with the fixed product was placed in vacuum baking equipment, vacuum pumping was firstly conducted, then nitrogen was filled, then heating was conducted according to a preset program, and reflow welding was conducted. The number of cycles can be increased by vacuum pumping and then filling nitrogen. The specific number of cycles depends on requirements.
7. The clamp was taken out from the baking equipment and the product was removed from the clamp after the reflow welding. To this end, the sealing welding operation of the optical window 16 was completed.

In conclusion, the optical window 16 and the base 12 of the laser encapsulation module 10 according to the present disclosure are welded by solder, which reduces the process difficulty of the laser encapsulation module 10 on the premise of ensuring the welding quality. The collimating lens 17 is installed on the optical window 16, so that the laser can be collimated and emitted. By providing the double-layer MPCB, the pad sealed in the accommodating space is led out through the inner circuit layer of the double-layer MPCB, which improves the process yield of the laser encapsulation module and enhances the sealing reliability of the laser encapsulation module.

The above embodiments merely show some embodiments of the present disclosure, which are specifically described in detail, but should not be construed as limiting the scope of the claims. It can be understood that those skilled in the art can make modifications and improvements without departing from the concept of the present disclosure, all of which fall within the protection scope of the present disclosure. Therefore, the protection scope of the present patent should be defined by the appended claims.

## Claims

1. A laser encapsulation module, comprising:
a base, wherein the base comprises a boss, an optical window pad, an inner pad and an outer pad, and the inner pad and the outer pad are conducted to each other through an inner circuit layer of the base;
an optical window welded on the optical window pad of the base, wherein the optical window and the base jointly form an accommodating space; and
a laser assembly, wherein the laser assembly is provided on the boss of the base and accommodated in the accommodating space, and is electrically connected to the inner pad, and wherein laser emitted by the laser assembly exits through the optical window.

2. The laser encapsulation module according to claim 1, further comprising a collimating lens installed at a side of the optical window away from the base, wherein the collimating lens is configured to shape light emitted from the laser assembly into parallel light.

3. The laser encapsulation module according to claim 2, wherein the collimating lens comprises two collimating lens units, and each collimating lens unit corresponds to one laser assembly to collimate the laser emitted by the laser assembly.

4. The laser encapsulation module according to claim 1, wherein the optical window has a hollow cylindrical structure, a cross section of the optical window in a direction perpendicular to the base is of a circular ring, and a width of the circular ring is less than a width of the optical window pad.

5. The laser encapsulation module according to claim 4, wherein the optical window comprises a side wall and a top wall, wherein the side wall enclose to form a ring shape and is connected to the top wall, a middle region of the top wall is provided with a light transmitting portion, and the light transmitting portion is configured to transmit light emitted from the laser assembly.

6. The laser encapsulation module according to claim 1, wherein the laser assembly comprises a laser chip, a heat sink carrier and a reflector, the heat sink carrier is provided on the boss of the base, the laser chip is provided on the heat sink carrier, and the reflector is provided in an optical path of light emitted from the laser chip.

7. The laser encapsulation module according to claim 6, wherein the reflector comprises a reflecting surface opposite to a light outlet of the laser chip, and the reflecting surface forms an included angle of 45° with a plane of the base.

8. The laser encapsulation module according to claim 7, wherein the laser assembly comprises a plurality of groups of laser chips and reflectors, and the plurality of groups of laser chips and reflectors are arranged in an array on the base.

9. The laser encapsulation module according to claim 1, wherein the base is a double-layer motor protection circuit board (MPCB), and a material of the double-layer MPCB is made of copper.

10. The laser encapsulation module according to claim 9, wherein the inner pad is arranged in the accommodating space, the outer pad is arranged outside the accommodating space, the double-layer MPCB comprises the inner circuit layer embedded in the base, and the inner pad and the outer pad are conducted to each other through the inner circuit layer.
